# EUROPEAN PATENT APPLICATION

(11) **EP 4 749 240 A1**
(43) Date of publication of application: **27.05.2026**
(21) Application number: 25217007.1
(22) Date of filing: 19.11.2025
(51) Int. Cl.: G01B 7/16, G01L 1/14, H03K 17/96

(54) **CAPACITIVE FLEX SENSOR**

(30) Priority: 21.11.2024 US 202463723293 P
(71) Applicant: Semtech Corporation, Camarillo CA 93012-8790 (US)
(72) Inventor: Rouaissia, Chaouki, 2000 Neuchâtel (CH)
(74) Representative: P&TS SA (AG, Ltd.)

(57) **Abstract**

A flex sensor with a pair of conductive electrodes on a flexible substrate that exhibit a variable mutual capacitance according to the amount of bending of the substrate, in that the shrinking or stretching of the substrate brings the electrode closer together, or further apart. The invention includes also an electronic circuit configured to measure a capacitance of at least one of the conductive electrodes and output a digital value representing a deflection or a deformation or a stress of the substrate.

## Description

### Technical domain

The present invention concerns, in embodiments, a flex sensor measuring the amount of deformation, deflection or bending of a flexible substrate.

### Related art

Flex sensors are used in several application, particularly, but not exclusively so, in human interface devices and small portable electronic appliances, and in innovative human-computer interfaces like datagloves and rehabilitation devices. Many electrical properties of materials can be used to traduce a deflection into a suitable electric signal.

Foldable devices are gaining more and more acceptance in the market of smartphones and portable electronic devices in general and their presence is expected to grow further. One of the key functions of these foldable devices is the capability of rearranging the display depending on the folding state. To this end, they generally rely on some form of detector that provides a folding state or, preferably, the folding angle. This may be achieved by a Hall sensor and a magnet positioned on opposite sides of the hinge; however, the choice of an optimal position that neutralizes or minimizes the negative influence of magnetic interferences is challenging.

Angle detectors in general are used in many applications including in the automotive industry where angle sensors are increasingly used in hood, trunk, door and seat mechanisms. There is therefore a need of an angle sensor that is inexpensive, robust and compatible with usual electronic fabrication techniques.

Known flex sensor may use conductive ink, in which the resistivity is altered according to the flex state, or strain, or other piezoresistive materials. Strain gauges may be regarded as an example of this, albeit for very small deflections. At the opposite end of the bending range, flex sensors on highly flexible substrates, like plastic films, are used to capture large deflections and bending angles up to 180° or more.

Optical flex sensors based on optical fibres and capacitive sensors are also known. US patent 5,610,528 discloses a capacitive sensor with two comb-shaped portions of conductive materials patterned each on a separate thin substrate. The combs are superposed and slide one relative to the other one when the substrate is bent.

Capacitive sensors are commonly used in electronic devices as proximity sensors and touch input devices. US patent 11,082,550 in the name of the present applicant provides an example, among many.

### Short disclosure of the invention

An aim of the present invention is the provision of a device that overcomes, at least in part, the shortcomings and limitations of the state of the art.

According to the invention, these aims are attained by the object of the attached claims. In its most general form, the inventive flex sensor comprises a pair of conductive electrodes on a flexible substrate that exhibit a variable mutual capacitance according to the amount of bending of the substrate, in that the shrinking or stretching of the substrate brings the electrode closer together, or further apart. The invention includes also an electronic circuit configured to measure a capacitance of at least one of the conductive electrodes and output a digital value representing a deflection or a deformation or a stress of the substrate. The sense electrodes are, preferably, on a common layer of a stacked substrate, but the invention would still function, to some extent, if the electrodes were placed on different layers, not too much far apart.

The sensor of the invention may be used to detect a simple elongation or shortening of the substrate, and in this case its position in the substrate is not important. An important use case, however, is the detection of bending. In this case there will be a neutral plane in the substrate whose elements are not deformed, and this neutral plane will often be in the middle of the thickness. It is important that the sensor be placed away from the neutral plane if bend detection is desired. A separation of at least 15% of the total substrate thickness is desirable.

The shape of the sense electrodes is not constrained, but interleaved combs have provided satisfactory results. Their dimensions may vary freely as the circumstances require. In many cases, it is desirable that the teeth of the combs be as fine and closely spaced as possible. In a typical FPC (flexible printed circuit) implementation of the invention, the teeth may have a width of 100-200 µm and will be separated by a space between 100 µm and 200 µm. Other processes, for example if the sensor is integrated in a flexible display, may lead to even finer teeth and spacings. Larger teeth widths and spacing are also possible, if the space is abundant.

In a simple implementation, the flex sensor of the invention may simply take a measure of the self-capacitance of one of the electrodes while the other is grounded, and derive from that an amount of deformation, or flexion, or a bend angle. In variants, the flex sensor of the invention may have also additional electrodes for shielding external influences. These may be permanently grounded or driven as active shields. There may be also a combination of active shields and further outside, protective electrodes that are permanently grounded. A plurality of additional electrodes is advantageous also because it allows to multiply the measurements in different conditions and in this way improves robustness against drifts of the capacitance that are not induced by deformation, flexion or bend. To the same end, it may also be preferable that the two combs forming the sense electrodes do not share a common teeth width and are measured separately while the other one is grounded.

In the context of the present disclosure the word "flexible" denotes materials that can bend and deform under external forces. When applied to printed circuits, it denotes mainly flexible circuits on polymeric substrates like polyimide, polyester, liquid crystal polymers and so on, but the invention can be extended to thin flexible layers of materials with a higher elastic modulus like FR-4, metals or ceramics. Similar considerations hold for flexible digital displays.

### Short description of the drawings

Exemplar embodiments of the invention are disclosed in the description and illustrated by the drawings in which:
Figure 1 illustrates schematically a portion of the flex sensor of the invention, implemented in a flexible stacked structure.
Figure 2 is a cut view of the stacked structure and
Figure 3 is a detail of the interleaved combs patterned on a layer of the stacked structure.
Figure 4 is, in a very simplified fashion, a possible architecture of an electronic circuit used in the invention.
Figure 5 is a simplified example, among many possible variants, of a circuit used in the invention to convert a self-capacitance of a generic electrode into a digital value.
Figure 6 shows schematically the flex detector of the invention on a deformed substrate.

In the figures, remarkable elements are identified by reference signs that are repeated in the text. The same reference sign may be used to identify distinct elements that are identical, similar, logically related, or technically equivalent. When many identical, similar, related or equivalent elements occur on a drawing, some reference signs may have been omitted to avoid cluttering.

### Examples of embodiments of the present invention

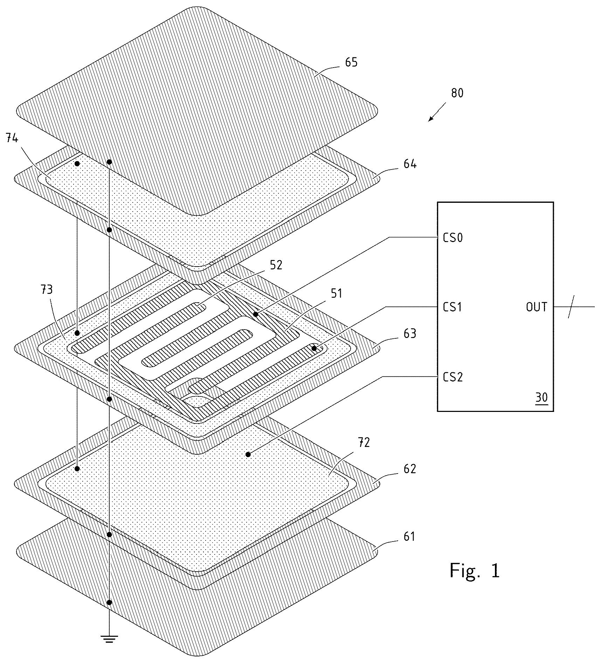

**Figure 1** represents, in simplified fashion and not to scale, a possible realization of the invention that includes a stacked structure 80 of patterned electrodes on a multi-layer flexible substrate. The structure 80 may be part of a flexible printed circuit, or of a flexible display and comprises an arrangement of patterned electrodes that will be disclosed hereafter. The electrodes may be patterned metallic layers, for example copper or, in the case of a flexible or foldable display, patterned conductive and transparent layers, for example layers of indium-tin oxide (ITO). Importantly, the patterned structure 80 is compatible with the usual fabrication methods of printed circuits and displays; thus, it can be integrated in many designs with little effort and costs. The various electrodes of the stacked structure 80 can be interconnected and connected to other electronic components with the usual tracks and vias. This is represented in the figure only schematically.

Figure 1 shows only the conductive electrodes of the stacked structure 80. The dielectric flexible layers on which the electrodes are patterned are not represented at all, to simplify.

At the centre of the multilayer structure 80 lie a pair of electrodes 51, 52. The electrodes are arranged in a way that, when the substrate is folded the relative distances between the electrodes are altered by the stretching of the layer-or the layers-on which the electrodes are patterned. Preferably, the electrodes 51 52 are shaped like two interleaved combs, and are on the same layer of the stack. Other solutions are possible, however.

The sense electrodes 51 52 are surrounded, on the same layer, by a shield ring 73 and, in the vertical direction, by shield electrodes 72 74 that lie on a lower, respectively higher layer of the stack. The shield ring and the upper and lower shield layer are electrically interconnected, for example by vias or in any other suitable way.

To further reduce the effect of external fields and disturbances, the shield ring 73 us surrounded by a larger ground ring 63 that is repeated also in the upper and lower layers by shield rings 64, 62. Moreover, the stack includes an upper ground plane 65 and a lower ground plane 61 on their separate layers. The ground planes and the ground rings may be permanently grounded or tied to a constant reference potential.

An electronic circuit 30 is connected to the shield electrodes ant to the two sense electrodes 51 52 and is configured to determine capacitively a deflection or deformation digital signal and provide a digital value of deflection, deformation or angle at its output, as it will be explained in the following.

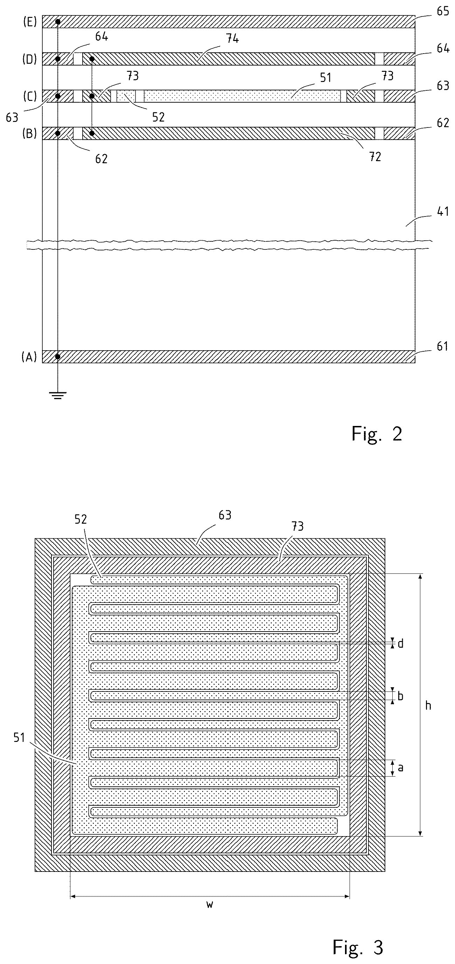

**Figure 2** shows the same structure, again not to scale, in section. The structure comprises five layers of patterned conductors labelled (A) to (E) on a flexible stack 41, which may be a part of a printed circuit or a display screen. The number of layers is not an essential feature of the invention, however, and other realization may include more layers, or less.

The sense electrodes 51, 52 are visible in the middle of layer (C), the latter partially hidden behind the former, and are surrounded by the shield ring 73 on the same layer, and the shield planes 72, 74 on layers (B) and (D). The shield rings and planes are interconnected by vias and form an electrostatic screen that protects the sense electrodes 51, 52 from external influences. They are connected by a track (not shown) to a terminal of the readout electronic circuit, that is programmed to drive the shield potential actively, as it will be disclosed later.

Preferably, the electrostatic screen is surrounded by the ground rings 62, 63, 64 on layers (B), (C), (D) and by ground planes 61, 65 on layers (A), (E). These conductors may be permanently grounded for further protection against external influences.

In figure 1 the sense electrodes are drawn as stylised interleaved combs. Tests have determined that this configuration provides a favourable sensitivity to flexion and deformation. **Figure 3** shows a detail of a structure of interleaved combs that can be used in the invention. The widths "a" and "b" of the teeth of combs 51, 52 may be identical (*a*/*b* ≈ 1) or different (*a*/*b ≠* 1). In a concrete realization on a printed circuit, the track separation d may be of 0.1 mm or less, to the limit allowable by the fabrication process, and the widths a, b may be between 0.1 mm and 10 mm or above, according to the needs. When the invention is applied to flexible displays, the dimensions a, b, d may be as small as the process allows, if needed. The overall width "w" and height "h" are not limited and, in many cases, may be considerably more than what the drawing shows.

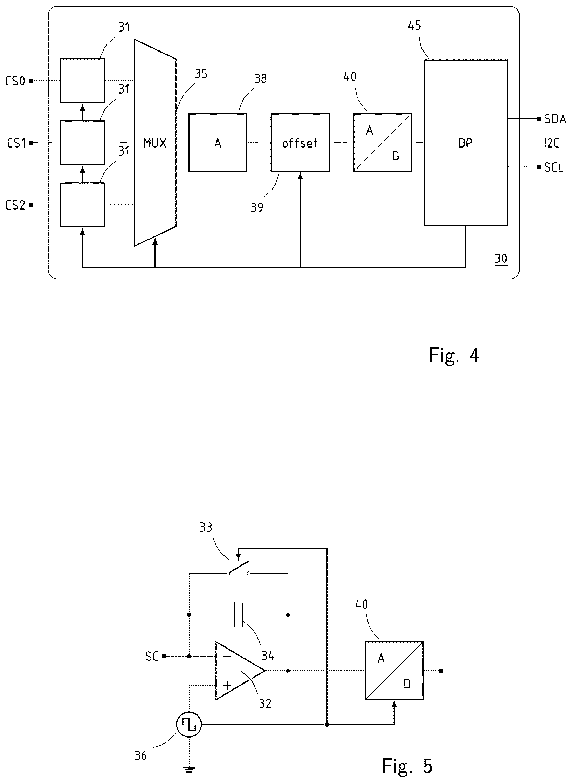

**Figure 4** shows an electronic circuit 30. The detector has three sense inputs CS0, CS1, CS2 connectable to the capacitive sense electrodes 51, 52 and to the shield electrodes.

Internally, the capacitive detector 30 has an analog/digital converter 40 that transform the capacitance signal to a digital signal suitable for further processing in a digital processor 45. Preferably, a common converter is used to read the capacitances seen by the sense electrodes in turn, through a multiplexer 35. This is not an absolute requirement, however.

The input units 31 are configured to set the corresponding input terminals to a desired state chosen among a measure state, a ground state, and a shield state. In the measure state, the electric potential of the input is variable, following a variable voltage source in the capacitive sensor device, and the resulting variation of electric charge are sent to the ADC to determine a capacitance value. In the ground state the input is held at a constant voltage, either the voltage of the ground or shifted by a fixed value. In the shield state, the voltage at the input follows that of another input that is in the measure state, but the variations of electric charge are disregarded.

**Figure 5** shows, in a very simplified form, a possible implementation of an input unit that causes the voltage at the input to follow a variable voltage source and could be used in the frame of this invention to convert a capacitance into a digital value with the ADC 40. This is provided for the completeness of the disclosure and by way of example, but the invention includes also other structures of input stages that can provide the desired function. The sense electrode is connected to the SC node that is linked to an inverting input of an amplifier 32, while the other input is driven by a voltage source 36 that can provide a variable voltage, or a constant voltage. Thanks to the feedback, the SC node is a low impedance one and its voltage is the same as that of the voltage source 36 (possibly with a constant offset that has no importance in this application).

The ground state of the input SC can be obtained by causing the source 36 to generate a constant voltage. The input node SC is then a virtual ground. The measure state and the shield state are obtained when the source 36 generates a variable voltage. Node SC follows then that voltage.

The capacitance of the sense electrode connected to the SC node can be measured by causing the source 36 to generate a series of steps. The capacitor 34 connected in the reaction loop gives an integrator and the output of the amplifier 32 will show steps proportional to the variation of electric charge on the sense electrode. The ratio between the charge, measurable as a step voltage at the output of amplifier 32, and the known voltage steps of the source 36 is, by definition, the capacitance that is sought. The switch 33 is used to discharge periodically the reaction capacitor 34.

The output signal is digitized by ADC converter 40, preferably synchronously with the pulses of the source 36. The multiplexer 35, preamplifier 38 and offset correction 39 are not represented in this figure but could be present.

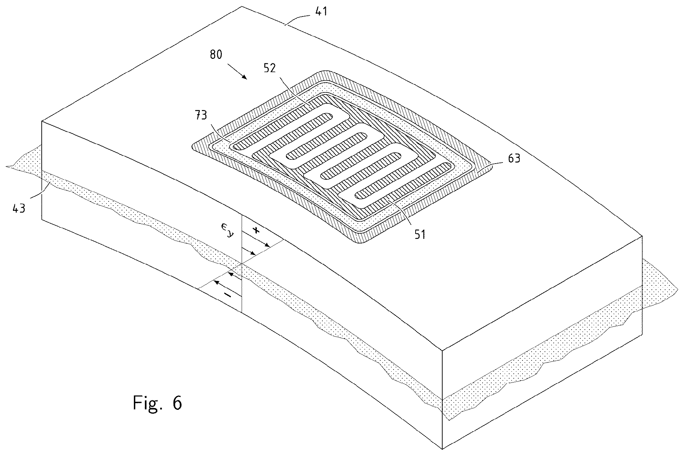

**Figure 6** is a simplified representation of the flex detector on a flexible deformed substrate 41. The bending impressed on the substrate generates a strain field that changes in function of the distance from the neutral sheet 43, in the middle. Above the neutral sheet the y component of the strain is positive *ε_{y}* > 0: the material is stretched. Below the sheet, *ε_{y} <* 0 and the material is compressed. When the detector stack 80 is patterned above the neutral sheet, as shown, the strain increases the gaps between the electrodes 51, 52 and their mutual capacitance decreases. Inversely, an opposite bend would cause a capacitance increase. The roles would be reversed for a detector below the neutral sheet. It appears that, by avoiding the neutral sheet when the sense electrodes 51, 52 are placed, it is in general possible to find a suitable position.

Advantageously, the detector of the invention is configured to perform several measurements with the electrodes in various modes to extract the deformation of the substrate. table 1 summarises some possible phases of the measurement and the corresponding settings of the input pins of the electronic circuit 30.

**table 1**

| | Phase 1 | Phase 2 | Phase 3 | Phase 4 |
|---|---|---|---|---|
| CS0 | Shield | Measure | Measure | Ground |
| CS1 | Shield | Ground | Measure | Measure |
| CS2 | Measure | Shield | Shield | Shield |

Not all the phases and input shown in the table are essential for the invention. In its simplest form, the invention may be embodied by a circuit with a single sense input, permanently in the "measure" mode, connected to one sense electrode, while the other sense electrode is grounded and no active shield is provided. The electronic circuit in this case may have only one input pin (CS0) and its operation would include only phase 2.

Additional phases and input pins increase precision and robustness. In phase 4, the role of the sense electrodes is exchanged: the electrode that was measured in phase 2 is tied to ground and the capacitance of the electrode that was grounded is now measured. This increases robustness against spurious signals. A genuine flexion signal is expected to yield proportional capacitances variations in phase 1 and in phase 4, linked by a geometric factor. This requires an additional pin (CS1) in the electronic circuit.

The addition of a third input pin (CS2) opens the possibility to connect the shield as active shields in phases 2 and 4. This minimizes the background self-capacitance of the sense electrodes and increases the relative capacitance change induced by flexion and deformations.

Phase 1 is a measure of the self-capacitance of the shield electrodes (connected to CS2) while the internal sense electrodes (CS0 and CS1) are used as active shield. The purpose of this measurement is to quantify background contributions not related to flexion or deformation of the substrate.

Phase 3 is a measurement of the capacitances of both sense electrodes (CS0 and CS1) while the shield is active. This is an alternative way to determine background contributions not related to flexion or deformation of the substrate.

According to the invention. The electronic circuit may be configured as an angle detector, delivering a logic signal when the bend goes beyond a predetermined angle, or returns below that value. This may be accomplished, in a simple embodiment, by checking the result M₂ of the measurement in phase 2 against a pair of thresholds: d₂ < *M*₂ < u₂. For extra robustness, the circuit may check also compare the phase 4 measurement *M*₄ against suitable thresholds: d₄ < *M*₄ < u₄ and raise the logic signal only when both criteria are met.

Phases 1 and 3 should not provide raised measurements during a genuine bend event, but react to unwanted external influences, like shocks, temperature drifts, approaching bodies, noise, electromagnetic interference. The electronic circuit of the invention may be configured to inhibit the bend signal when the corresponding measurements *M*₁, *M*₃ go beyond their expected values:

Besides the angle detection, the invention may consent the measurement of the bend angle, based on the values of *M*₂ and *M*₄. This can be achieved by look-up tables, or calculation (possibly evaluating a formula that has been fitted to the response of the flex sensor in a calibration).

### Reference symbols in the figures

- 30: electronic circuit
- 31: front-end
- 32: amplifier
- 33: reset switch
- 34: integration capacitor
- 35: multiplexer
- 36: variable voltage source
- 38: analogue processing
- 39: offset compensation
- 40: A/D converter
- 41: substrate
- 43: neutral layer
- 45: digital processing
- 51: first comb electrode
- 52: second comb electrode
- 61: ground surface
- 62: ground ring
- 63: ground ring
- 64: ground ring
- 65: ground surface
- 72: shield surface
- 73: shield ring
- 74: shield surface
- 80: stacked structure

## Claims

1. A flex sensor comprising a pair of conductive electrodes (51, 52) patterned on a flexible substrate (41), wherein a mutual capacitance between the conductive electrodes of the pair of conductive electrodes is variable according to an amount of bending of the substrate and an electronic circuit (30) configured to measure a capacitance of at least one of the conductive electrodes and output a digital value representing a deflection or a deformation or a stress of the substrate.

2. The flex sensor of the preceding claim in which the conductive electrodes (51, 52) are surrounded by one or more shield electrodes (72, 73, 74) and wherein the electronic circuit (30) is configured to maintain a constant potential difference between the one or more shield electrodes and the conductive electrode whose capacitance is measured.

3. The flex sensor of the preceding claim, the flexible substrate being a layer of a flexible stacked assembly, the shield electrodes comprising one or more of:
- shield rings (73) patterned on the flexible substrate
- shield surfaces (72, 74) patterned on layers of the printed circuit board below or above the flexible substrate.

4. The flex sensor of any one of claims 2-3, comprising one or more ground surfaces (65) surrounding the shield electrodes.

5. The flex sensor of any one of the preceding claims, wherein the pair of conductive electrodes (51, 52) are interleaved combs having a same tooth width or a first comb having a first tooth width interleaved with a second comb having a second tooth width different from the first one.

6. The flex sensor of any one of the preceding claims, the electronic circuit (30) being configured to measure, in a first measuring phase, a capacitance of a first electrode of the pair while the second electrode of the pair is held at a constant reference potential.

7. The flex sensor of claims 6 and 2, wherein the electronic circuit (30) is configured to measure in a second measuring phase a capacitance of the second electrode while the first electrode is connected to a constant reference potential and the shield electrodes are kept at a constant voltage difference from the second electrode.

8. The flex sensor of any one of claims 6-7, the electronic circuit (30) being configured to measure in a third measuring phase a capacitance appearing on the shield electrode while the first and second input are kept at a constant voltage difference from the shield electrode.

9. The flex sensor of any one of claims 6-8, the electronic circuit (30) being configured to measure in a fourth measuring phase a capacitance appearing collectively on the first and second electrode, while the shield electrode is kept at a constant voltage difference from the first and second electrodes.

10. The flex sensor of any one of the preceding claims, the flexible substrate (41) being a layer of a flexible printed circuit or a layer of a foldable display
